# EUROPÄISCHE PATENTSCHRIFT

(11) **EP 2 921 833 B1**
(45) Veröffentlichungstag und Bekanntmachung des Hinweises auf die Patenterteilung: **28.12.2016**
(21) Anmeldenummer: 14160420.7
(22) Anmeldetag: 18.03.2014
(51) Int. Cl.: G01K 17/00, H05K 3/32

(54) **Thermoanalytischer Sensor und Verfahren zu dessen Herstellung**
Thermoanalytical sensor and method for its production
Capteur thermo-analytique et procédé destiné à sa fabrication

(43) Veröffentlichungstag der Anmeldung: 23.09.2015
(73) Patentinhaber: Mettler-Toledo GmbH, 8606 Greifensee (CH)
(72) Erfinder: Wettstein, Paul, 5507 Mellingen (CH); Bendler, Markus, 8126 Zumikon (CH)

(56) Entgegenhaltungen:
- EP-A2- 2 700 924
- WO-A2-2013/128341
- DE-T2- 69 730 699
- JP-A- 2003 315 164
- US-A1- 2006 228 825

## Beschreibung

Die Erfindung betrifft einen thermoanalytischen Sensor und ein Verfahren zu dessen Herstellung.

Thermoanalytische Sensoren werden in geeigneten Thermoanalyse-Geräten eingesetzt, um verschiedene Eigenschaften und Parameter einer Probe bei Temperatur-Änderungen zu ermitteln.

Bekannte Beispiele für Thermoanalyse-Geräte sind unter anderem DSC-Geräte (DSC - differential scanning calorimetry). DSC-Geräte werden eingesetzt, um temperaturabhängige Änderungen der chemischen oder physikalischen Eigenschaften einer Probe bzw. einer Material-Probe zu ermitteln. Dazu zählen beispielsweise Wärmeflussmessungen von exothermen oder endothermen Ereignissen die einen Übergang, wie zum Beispiel einen Phasenübergang, begleiten sowie auch andere Effekte welche in einer Probe auftreten, die Temperaturänderungen unterworfen wird. Die Änderungen in der Probe können im Vergleich zu einer Referenz ermittelt werden, welche entweder die leere Referenz-Messposition oder ein geeignetes Referenz-Material sein kann. Abhängig von der Art des DSC-Geräts kann das Referenz- oder Probenmaterial direkt oder in einem geeigneten Gefäss auf die jeweilige Messposition platziert werden. Thermoanalytische Sensoren können zudem auch in weiteren Geräten eingesetzt werden, wie beispielsweise TGA-DSC Geräten (TGA: thermogravimetric analysis) oder HP-DSC Geräten (High-Pressure DCS) ebenso wie in weiteren bekannten Geräten mit thermoanalytischen Sensoren.

Thermoanalyse-Geräte werden häufig im "heat flux" und "power compensation" Modus betrieben.

Bei der Power Compensation wird die zugeführte Heizleistung einer Heizung und/oder die Heizleistung einer Kompensationsheizung so gesteuert und kontrolliert, dass die Temperaturdifferenz zwischen Referenz- und Probenposition gegen Null geregelt wird. Aus der dafür aufzubringenden Leistung kann auf den Wärmefluss in die Probe zurückgeschlossen werden. Im Idealfall entspricht die aufzubringende Leistung dem Wärmefluss in die Probe.

Das Heat-Flux-Prinzip wird häufig in Thermoanalyse Geräten mit einem gemeinsamen Halter für die Probe und die Referenz eingesetzt. Die Wärmeflusspfade zwischen den Messpositionen und der Heizung sollten bekannt sein, so dass jegliche Temperaturdifferenz zwischen den beiden Messpositionen idealerweise nur von Änderungen in der Probe herrührt. Die Wärmeflüsse können anhand der realen Temperaturen an der Proben- und Referenzposition berechnet und quantitativ ausgewertet werden.

Thermoanalytische Sensoren für solche Geräte sind häufig scheibenförmig und weisen auf einer Oberfläche mindestens eine Messposition auf, die mit einer Temperatur-Sensoreinheit verbunden ist, welche die Temperatur an der jeweiligen Messposition und/oder die Differentialtemperatur zwischen einer Proben- und einer Referenzposition erfasst. Der Sensor und damit die mindestens eine Messposition können über eine angeschlossene Heizung mit Wärme und insbesondere mit einem geeigneten Temperatur-Zeit-Programm zur Erzeugung von Temperaturänderungen beaufschlagt werden.

Es sind verschiedene Ausführungen solcher thermoanalytischen Sensoren bekannt.

F. X. Eder, Arbeitsmethoden der Thermodynamik, Band 2, Springer-Verlag 1983 S.240 offenbart zum Beispiel einen Sensor, welcher eine Temperatur-Sensoreinheit umfasst, die in Dünnfilmtechnik auf einem Substrat aufgebracht ist.

DE 39 16 311 C2 offenbart einen Sensor mit einer in Dickfilmtechnik aufgebrachten Temperatur-Sensoreinheit.

Gemeinsam ist diesen Sensoren, dass die Temperatur-Sensoreinheiten pro Messposition mehrere Thermokontakte oder Thermoelemente umfassen, welche direkt auf einer Sensoroberfläche ausgebildet sind.

Sensoren mit Temperatur-Sensoreinheiten aus einer Vielzahl von Thermoelementen werden zudem in EP 1 528 392 A1, DE 10 227 182 A1, DE 39 16 311 A1 und WO 2006/114394 A1 offenbart. Diese Schriften offenbaren Sensoren mit einer oder mehreren Messpositionen, wobei die Temperatur-Sensoreinheiten in unterschiedlichen Techniken und/oder Mustern auf der Sensoroberfläche aufgebracht wurden, um beispielsweise die Anzahl der Thermoelemente pro Messposition zu erhöhen oder durch Ausbildung von Thermoelementen in mehreren Lagen oder Ebenen des Sensors eine mehrdimensionale Temperaturmessung zu ermöglichen.

Ein weiterer Temperatursensor der in Dünnfilmtechnik auf einem Substrat angebracht ist, ist in der JP 2003 315164 A beschrieben.

Gemeinsam ist diesen Sensoren, dass jede Messposition mit einer Temperatur-Sensoreinheit verbunden ist, welche hier insbesondere als Thermoelementanordnung in Dünn- oder Dickfilmtechnik um die Messposition herum auf der Oberseite eines Substrats ausgebildet ist. Jede Thermoelementanordnung ist durch das Substrat hindurch über eine elektrische Kontaktstelle und mindestens einen geeigneten metallischen Draht mit einem elektronischen Schaltkreis verbunden. Ein Ende, das obere Ende, des metallischen Drahts ist von der Oberseite des Substrats an die elektrische Kontaktstelle der Temperatur-Sensoreinheit gebondet, um eine stoffschlüssige Verbindung in Form einer Bondstelle zwischen dem Schaltkreis und der Temperatur-Sensoreinheit herzustellen, wobei bei der Befestigung des metallischen Drahts jeweils eine Draht-Schlaufe auf der Oberseite des Substrats entsteht.

Das Kontaktieren oder Bonden des Schaltkreises mittels des mindestens einen metallischen Drahts von oben, also von der Oberseite des Sensors, unter Ausbildung jeweils einer Draht-Schlaufe hat den Nachteil, dass so einerseits die Gesamt-Anzahl der möglichen Verbindungen oder Kontakte auf Grund der Raumerfüllung der Draht-Schlaufen auf der Oberseite des Sensors stark beschränkt ist und zudem diese Draht-Schlaufen beim Aufbringen oder Entfernen eines eine Probe enthaltenen Tiegels leicht verletzt und/oder getrennt werden können, wodurch der Sensor funktionsunfähig wird.

Die Aufgabe besteht somit in der Bereitstellung eines besonders robusten und anwenderfreundlichen Sensors, welcher zudem die Anordnung einer Vielzahl von Kontakten auf der Oberseite des Sensors erlaubt.

Gelöst wird diese Aufgabe durch ein Verfahren zu Herstellung eines thermoanalytischen Sensors sowie eines nach diesem Verfahren hergestellten thermoanalytischen Sensors, welcher ein Substrat mit einer Oberseite und einer Unterseite, mindestens einer Messposition, mindestens einer Temperatur-Sensoreinheit und mindestens einer elektrische Kontaktstelle umfasst. Die mindestens eine Messposition, die mindestens eine Temperatur-Sensoreinheit und die elektrische Kontaktstelle sind auf der Oberseite des Sensors ausgebildet, wobei die Temperatur-Sensoreinheit die Temperatur an der Messposition erfasst. Die Temperatur-Sensoreinheit ist über die elektrische Kontaktstelle mit einem metallischen Draht zur Einbindung in eine elektronische Schaltung verbunden. Das Verfahren umfasst dabei die folgenden Schritte: Nach Bereitstellen des Substrats wird mindesten eine Messposition, mindestens eine Temperatur-Sensoreinheit und mindestens eine elektrische Kontaktstelle auf der Oberseite des Substrats erzeugt. Zudem wird mindestens eine Durchführung im Substrat zur Kontaktierung der elektrischen Kontaktstelle erzeugt. Anschliessend wird ein metallischer Draht von der Unterseite des Substrats aus in die Durchführung eingeführt und das obere Ende des metallischen Drahtes, welches an der Oberseite des Substrats herausragt unter Ausbildung einer Metallkugel aufgeschmolzen. Abschliessend wird als Bondstelle eine stoffschlüssige Verbindung zwischen dem oberen Ende des metallischen Drahts und der elektrischen Kontaktstelle erzeugt, Dies wird erreicht, indem die Metallkugel unter Einwirkung von Druck- und Temperatur aufgeschmolzen wird und dadurch der Draht an die Kontaktstelle gebondet wird.

Diese Art des Bondens ist gerade für thermoanalytische Sensoren besonders vorteilhaft, da auf diese Weise die Bildung von nachteiligen Drahtschlaufen auf der Oberseite des Sensors vermieden werden kann. Die Bondstelle ist auf der Oberseite des Sensors nur als kompakte metallische Ausbuchtung ausgebildet, welche sehr flach ist und keine Angriffspunkte bei der Beschickung des Sensors mit einer Probe oder der Entfernung der Probe aufweist. Vorzugsweise ist die Temperatur-Sensoreinheit über zwei Kontaktstellen unter Ausbildung von zwei Bondstellen an zwei metallische Drähte gebondet oder mit diesen verbunden.

Die Temperatur-Sensoreinheit kann zudem über die elektrische Kontaktstelle und einen metallischen Draht in eine elektronische Schaltung eingebunden werden.

Das Verfahren kann ferner die Ausbildung von zwei oder mehr Messpositionen und zwei oder mehr Temperatur-Sensoreinheiten auf der Oberseite des Sensors umfassen, wobei jeder Messposition eine individuelle Temperatur-Sensoreinheit zugeordnet ist.

Diese Herstellungsmethode ist zudem sehr geeignet für die Herstellung von Sensoren mit eine Vielzahl von Messpositionen, Kontaktstellen zum Abgreifen von Sensorsignalen zur Bestimmung von verschiedenen Parameter, wie z.B. Temperatur, Differentialtemperatur zwischen den Messpositionen, Druck, Feuchte und/oder Durchfluss und/oder zum Anlegen von elektrischen Spannungen zur Versorgung von z. B. Widerstandsheizungen und/oder zur Sensorspeisung, da die resultierenden Bondstellen sehr viel weniger raumerfüllend sind, so dass es möglich wird, eine grössere Anzahl von Bondstellen auf dem Sensor zu erzeugen. Auf einem thermoanalytischen Sensor gleichbleibenden Durchmessers, kann so zumindest die zwei- bis dreifache, insbesondere sogar die fünffache, Anzahl an Bondstellen untergebracht werden.

Die Temperatur-Sensoreinheit kann als Thermoelementanordnung ausgebildet sein, welche mindesten zwei Thermoelemente umfasst, die in einer oder mehreren Sensorlagen auf der Oberseite des Sensors ausgebildet werden. Die Temperatur-Sensoreinheit kann auch einen oder mehrere Widerstands-Temperatur-Sensoren, wie beispielsweise Pt-100 Sensoren, umfassen.

Das Verfahren kann ferner die Ausbildung mindestens eines Heizwiderstands und mindestens einer weiteren elektrischen Kontaktstelle auf der Oberseite des Sensors sowie einer weiteren Durchführung im Sensor umfassen, wobei der Heizwiderstand zum Heizen der mindestens einen Messposition dient und über die elektrische Kontaktstelle mit einem weiteren metallischen Draht zur Verbindung mit einer elektrischen Stromversorgung oder Speisung verbunden ist, und wobei zwischen einer am oberen Ende des weiteren metallischen Drahts ausgebildeten Metallkugel und der elektrischen Kontaktstelle eine stoffschlüssige Verbindung in Form einer Bondstelle erzeugt wird. Der Heizwiderstand ist vorzugsweise über zwei Kontaktstellen an zwei metallische Drähte gebondet.

Das Verfahren eignet sich somit insbesondere für die Herstellung von Sensoren mit unterschiedlichen elektrisch anzuschliessenden Elementen auf der Oberseite des Sensors.

Vorzugsweise sind die Temperatur-Sensoreinheit, der Heizwiderstand und/oder die elektrische Kontaktstelle in Dick- oder Dünnfilmtechnik auf der Oberseite des Sensors ausgebildet.

Die für das Bonden eingesetzten metallischen Drähte umfassen vorzugsweise mindestens eines der folgenden Metalle oder Legierungen daraus: Gold, Palladium und Kupfer. Diese sind aufgrund ihrer Materialeigenschaften besonders vorteilhaft für die Ausbildung der Metallkugel und der nachfolgenden Kontaktierung der Kontaktstelle.

Der metallische Draht kann einen Durchmesser zwischen ca. 0.01 mm und ca. 0.25 mm und insbesondere einen Durchmesser von ca. 0.1 mm aufweisen.

Die Metallkugel wird vorzugsweise mit einem Durchmesser erzeugt, welcher dem ein- bis fünffachen des Drahtdurchmessers entspricht. Die Grösse der Metallkugel kann auf Grund der experimentellen Bedingungen sehr genau kontrolliert werden. Für einen Golddraht mit einem Durchmesser von 0.1 mm wird dafür eine Funkenentladung von ca. 2-5 kV benötigt.

Die elektronische Schaltung des thermoanalytischen Sensors kann so ausgelegt werden, dass mit dem Sensor eine DSC Messung nach dem Prinzip der Power Compensation und/oder dem Heat-Flux-Prinzip durchführt werden kann.

Ein weiterer Aspekt der Erfindung betrifft die Bereitstellung eines nach dem beschriebenen Verfahren hergestellten thermoanalytischen Sensors, insbesondere eines DSC-Sensors, welcher ein Substrat mit einer Oberseite und einer Unterseite umfasst und auf dessen Oberseite mindestens eine Messposition, eine Temperatur-Sensoreinheit und mindestens eine elektrische Kontaktstelle ausgebildet sind. Die Temperatur-Sensoreinheit erfasst die Temperatur der Messposition und ist über die elektrische Kontaktstelle mit mindestens einem metallischen Draht zur Einbindung in eine elektronische Schaltung verbunden. Der metallische Draht ist von der Unterseite des Substrats in eine im Substrat ausgebildete Durchführung eingebracht und an dessen oberen Ende ist eine Metallkugel ausgebildet, welche Metallkugel unter Druck- und Temperatureinwirkung eine stoffschlüssige Verbindung als Bondstelle zwischen dem oberen Ende des metallischen Drahts und der elektrischen Kontaktstelle ausbildet.

Der Sensor kann ferner mindestens einen Heizwiderstand und mindestens eine weitere elektrische Kontaktstelle umfassen, welche auf der Oberseite des Sensors ausgebildet sind, wobei der Heizwiderstand über die elektrische Kontaktstelle mit einem weiteren metallischen Draht zur Verbindung mit einer elektrischen Stromversorgung oder Speisung verbunden ist und zum Heizen der mindestens einen Messposition dient.

Das Substrat kann ein leitendes oder ein nicht-leitendes Material umfassen, wie beispielsweise Metalle oder keramische Materialien. Beispiele für leitende Materialien umfassen unter anderem Stahl und/oder andere Hartmetalle. Als nicht-leitende Materialien können beispielsweise folgende Materialien oder Mischungen daraus verwendet werden: Aluminiumoxid, Steatit, Aluminiumnitrit und Glaskeramik.

Ferner ist das Substrat im Wesentlichen scheibenförmig ausgebildet und umfasst eine im Wesentlichen ebene Oberseite auf welcher zumindest die mindestens eine Messposition ausgebildet ist.

Das erfindungsgemässe Verfahren sowie verschiedene Ausführungsbeispiele eines nach diesem Verfahren hergestellten thermoanalytischen Sensors werden im Folgenden anhand der Figuren näher beschrieben, wobei gleiche Elemente mit gleichen oder ähnlichen Bezugszeichen versehen sind. Die Figuren zeigen:
- Fig. 1: einen bekannten thermoanalytischen Sensor mit zwei Messpositionen als dreidimensionale Darstellung und als Seitenansicht;
- Fig. 2: einen erfindungsgemässen thermoanalytischen Sensor mit zwei Messpositionen als dreidimensionale Darstellung und als Seitenansicht;
- Fig. 3: eine schematische Teildarstellung eines erfindungsgemässen thermoanalytischen Sensors mit zwei elektrischen Kontaktstellen im Schnitt mit A: eingeführten metallischen Drähten; B: eingeführten metallischen Drähten und ausgebildeten endständigen Metallkugeln; C: einer stoffschlüssigen Verbindung zwischen den elektrischen Kontaktstellen und den metallischen Drähten.
- Fig. 4: Aufsicht auf einen ersten thermoanalytischen Sensor mit einer Messposition;
- Fig. 5: Aufsicht auf einen zweiten thermoanalytischen Sensor mit zwei Messpositionen;
- Fig. 6: Aufsicht auf einen dritten thermoanalytischen Sensor mit zwei Messpositionen;
- Fig. 7: Aufsicht auf einen weiteren thermoanalytischen Sensor mit vier Messpositionen;
- Fig. 8: eine schematische Darstellung eines Differenzkalorimeters mit einem erfindungsgemässen thermoanalytischen Sensor.

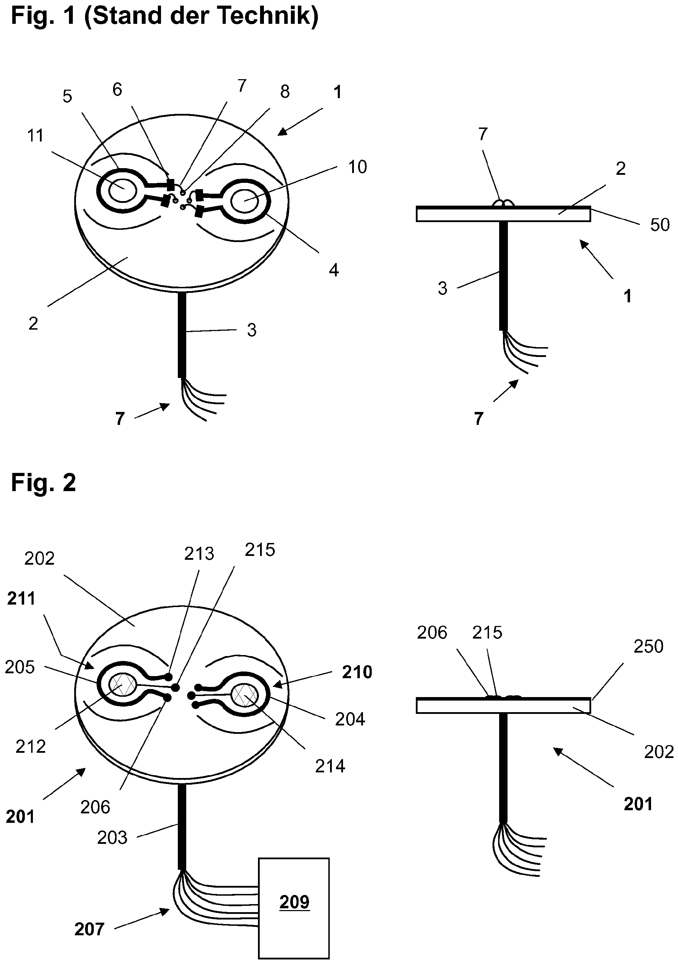

Figur 1 zeigt schematisch einen bekannten thermoanalytischen Sensor 1 als dreidimensionale Ansicht und als Seitenansicht. Der thermoanalytische Sensor 1 umfasst ein scheibenförmiges Substrat 2 mit einer Oberseite und einer Unterseite, welches hier beispielsweise einen keramischen Werkstoff umfasst. Auf der Oberseite des Sensors 1 sind zwei Messpositionen 10, 11 und zwei Temperatur-Sensoreinheiten 4, 5 ausgebildet, die hier nur angedeutet sind. Die Temperatur-Sensoreinheiten 4, 5 sind so ausgerichtet, dass sie die jeweilige Messposition 10, 11 im Wesentlichen konzentrisch umgeben, so dass eine Temperaturänderung möglichst genau erfasst werden kann. Die Temperatur-Sensoreinheit 4, 5 einer Messposition 10, 11 kann beispielsweise eine Vielzahl von Thermokontakte oder Thermoelementen umfassen, welche in Reihe zu einer Thermoelementanordnung zusammengeschaltet sind. Diese Thermokontakte oder Thermoelemente können zum Beispiel in Dick- oder Dünnfilmtechnik auf das Substrat 2 aufgebracht werden, welche in der Seitenansicht als Schicht 50 angedeutet ist. Weiterhin umfasst jede der Temperatur-Sensoreinheiten 4, 5 eine Kontaktstelle 6, welche wie hier zu erkennen ist mit einem dünnen metallischen Draht 7 verbunden ist, welcher durch eine Durchführung 8 im Substrat 2 zur Unterseite des Substrats 2 geführt ist. Alle metallischen Drähte 7 sind in einer Hülse 3 geführt, welche wie eine Art Stiel unter dem Substrat 2 angeordnet ist. Die Hülse 3 ist vorzugsweise als Mehrlochkapillare ausgebildet, so dass die metallischen Drähte isoliert voneinander geführt werden können. Die aus der Hülse 3 austretenden, freien Enden der metallischen Drähte 7 werden in einen elektronischen Schaltkreis eingebunden (siehe Figur 2), so dass die Temperatur-Sensoreinheiten 10, 11 mit einer geeigneten Steuerung verbunden werden können und so die Messdaten ausgelesen werden können. Die metallischen Drähte 7 können dabei in einem gemeinsamen Schaltkreis oder auch in getrennte Schaltkreise eingebunden werden.

In der ebenfalls in Figur 1 gezeigten Seitenansicht ist klar zu erkennen, dass die metallischen Drähte 7 zwischen der Kontaktstelle 6 und der Durchführung 8 jeweils eine Schlaufe ausbilden. In der Praxis hat sich diese Schlaufe als sehr nachteilig erwiesen, da der metallische Draht 7 an dieser Stelle beim Aufsetzen oder Entfernen einer Probe oder eines Probengefässes leicht beschädigt oder gar abgerissen werden kann, was zum Funktionsverlust oder sogar zur Zerstörung des Sensors 1 führen kann.

Figur 2 zeigt eine schematische dreidimensionale Ansicht sowie eine Seitenansicht eines erfindungsgemässen Sensors 201, welcher ebenfalls ein Substrat 202 und zwei darauf angeordnete Messpositionen 210, 211 umfasst.

Jede der Messpositionen 210, 211 weist sowohl eine Temperatur-Sensoreinheit 204, 205 auf, sowie auch einen Heizwiderstand 212, 214, welcher beispielsweise als Kompensationsheizung für einen Betrieb im Power Compensations Modus dienen kann. Die Temperatur-Sensoreinheiten 204, 205 bestehen auch in diesem Ausführungsbeispiel aus einer Vielzahl von in Reihe zu einer Thermoelementanordnung zusammengeschalteten Thermoelementen.

Die Heizwiderstände 212, 214 und auch die Temperatur-Sensoreinheiten 204, 205 sind auf der Oberseite des Substrats 202 in Dick- oder Dünnfilmtechnik ausgebildet, wie es in durch eine Schicht 250 in der Seitenansicht angedeutet ist, und weisen jeweils eine Kontaktstelle 206, 213, 215 auf. Diese Elemente werden wie bereits im Zusammenhang mit Figur 1 beschrieben jeweils an der Kontaktstelle 206, 213, 215 über geeignete metallische Drähte 207, wie hier angedeutet, in einen oder mehrere elektronischen Schaltkreise 209 eingebunden. Die Kontaktierung zwischen der Kontaktstelle 206, 213, 215 und den jeweiligen Drähten 207 erfolgt auch hier durch Bonden, jedoch wird keine Schlaufe auf der Oberseite des Substrats ausgebildet. Nach dem Verbinden mit den metallischen Drähten 207 sind die Kontaktstellen 206, 215 in der Seitenansicht als flache Erhebungen zu erkennen.

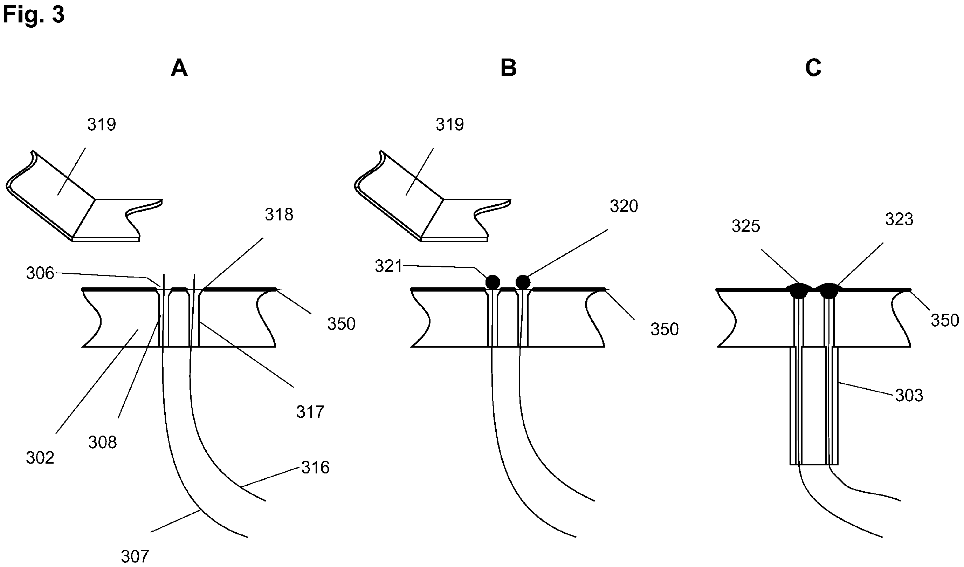

Das Verfahren zum Herstellen eines derartigen erfindungsgemässen thermoanalytischen Sensors mit einem Substrat 302, welche eine Schicht 350 mit unter anderem mindestens einer in Dünn- oder Dickfilmtechnik aufgebrachten Kontaktstelle, mindestens eine Messposition und mindestens eine Temperatur-Sensoreinheit aufweist, ist schematisch in den Figuren 3A bis 3C gezeigt.

Das Substrat 302 weist wie in Figur 3A gezeigt zwei Durchführungen 308, 317 auf, in welche von der Unterseite des Sensors jeweils ein metallischer Draht 307, 316 eingeführt wird. Am oberen Ende des Drahts 307, 316 wird mit einem geeigneten Werkzeug 319 unter kontrollierten Temperaturbedingungen das Drahtende zu jeweils eine Metallkugel 320, 321 aufgeschmolzen (s. Figur 3B). Dieses geschieht vorzugsweise durch Applikation von elektrischer Energie.

Um eine Metallkugel mit einem Durchmesser von ca. 0.4 mm am oberen Ende eines Drahtes mit einer Dicke von ca. 0.1 mm zu bilden, ist eine Funkenentladung von ca. 2-5 kV notwendig, wenn der Draht im Wesentlichen aus Gold besteht. Die benötigte Spannung muss sowohl an das Material des Drahtes, dessen Dicke sowie den gewünschten Kugeldurchmesser angepasst sein. Der metallische Draht umfasst vorzugweise mindesten eines der folgenden Metalle und/oder Mischungen daraus: Gold, Palladium, Kupfer. Besonders bevorzugt ist die Verwendung eines im Wesentlichen aus Gold bestehenden Drahts.

In einem weiteren Schritt werden die so ausgebildeten Metallkugeln 321, 320 unter Druck- und Temperatureinfluss angeschmolzen und auf die Kontaktstelle gepresst, so dass sich eine stoffschlüssige Verbindung zwischen einer auf der Oberseite des Substrats 302 befindlichen Kontaktstelle einer Temperatur-Sensoreinheit (s. Figur 2) und dem metallischen Draht 316, 307 ausbildet (s. Figur 3C). Der Draht 307, 316 ist nun an die Kontaktstelle 323, 325 gebondet. Ein derartiges Bondverfahren wird auch als Thermokompression bezeichnet. Die an der Unterseite des Substrats 302 austretenden Drähte 307, 316 werden abschliessend auf die gewünschte Länge gekürzt und von einer Hülse 303 umgeben. Die Hülse 303 ist vorzugsweise eine Mehrkapillarhülse in welcher die Drähte 307, 316 von einander elektrisch und thermisch isoliert geführt sind.

Für einen Draht mit den zuvor beschriebenen Dimensionen werden Drücke von ca. 10 bis ca. 100 N und Temperaturen von ca. 300°C zur Herstellung der stoffschlüssigen Verbindung benötigt, wobei die notwendige Temperatur vom Material des Drahts abhängig ist.

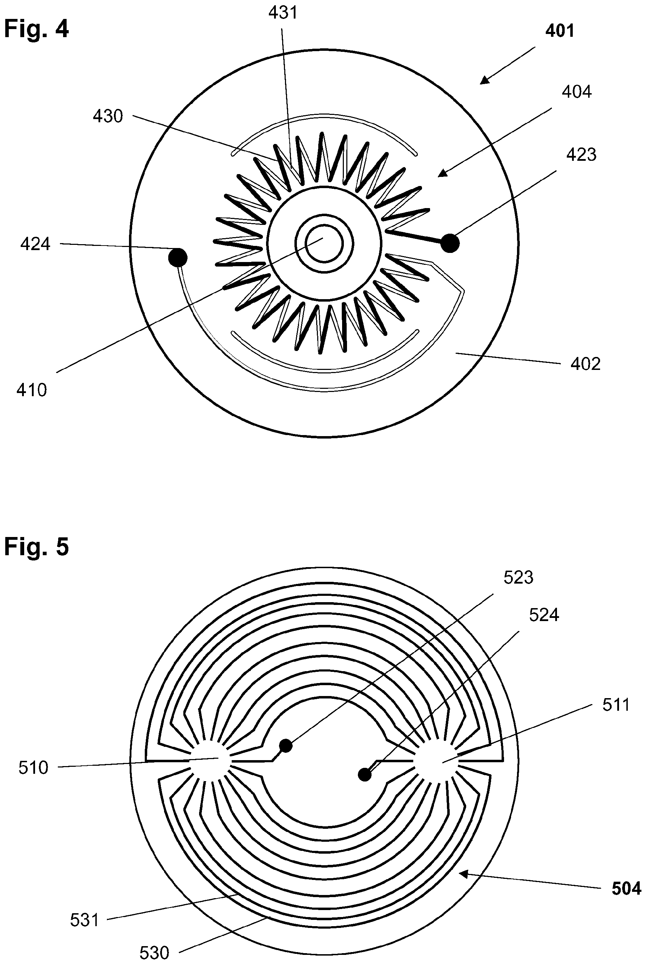

Die Figuren 4 bis 7 zeigen verschiedene Ausführungsbeispiele eines erfindungsgemässen thermoanalytischen Sensors in der Aufsicht.

Figur 4 zeigt einen Sensor 401 mit einer einzelnen Messposition 410 auf einer Oberseite eines Substrats 402, welcher von einer sternförmig angelegten Temperatur-Sensoreinheit 404 umgeben ist. Die Temperatur-Sensoreinheit 405 besteht aus einer Vielzahl von Thermoelementen 430, 431 aus zwei verschiedenen Thermokontaktmaterialien, welche im Wechsel auf das Substrat 402 aufgebracht wurden. Dort wo sich die beiden Thermokontaktmaterialien treffen bildet sich jeweils ein Thermokontakt aus. Die Temperatur-Sensoreinheit 404 ist an beiden Enden über jeweils eine Kontaktstelle 423, 424 an metallische Drähte gebondet, welche in dieser Aufsicht nicht zu sehen sind. Ähnliche Temperatur-Sensoreinheiten sind beispielsweise aus EP 0 990 893 A1 bekannt.

Figur 5 zeigt ein weiteres Ausführungsbeispiel eines thermoanalytischen Sensors mit zwei auf einem Substrat 502 ausgebildeten Messpositionen 510,511.

Das Substrat 502 ist eine im Wesentlichen kreisförmige Scheibe, welche aus einem der zuvor beschriebenen Materialien besteht. Auf der Oberseite des Substrats ist in Dickfilmtechnik mindestens eine Temperatur-Sensoreinheit aufgebracht, welche aus einer Vielzahl - hier zwanzig - einzelner in Reihe geschalteter Thermoelemente 530, 531 besteht, die jeweils aus zwei verschiedenen Edelmetallen bestehen Die Thermoelemente 530, 531 sind jeweils kreisförmig um die beiden Messpositionen 510, 511 herum angeordnet, wobei am Ende der Temperatur-Sensoreinheit 504 an jeder der beiden Messpositionen 510, 511 jeweils eine Kontaktstelle 523, 524 angeordnet ist, über diese ist die Temperatur-Sensoreinheit 504 nach dem Bonden an einen geeigneten metallischen Draht in einen elektronischen Schaltkreis eingebunden. Die Thermoelemente 530,531 beschreiben zwischen den Messpositionen 510, 511 Halbkreise, welche wie hier gezeigt kreisrund oder auch polygon ausgebildet sein können. Die Thermoelemente 530, 531 sind in einem ausreichenden Abstand voneinander angeordnet, so dass sie parallel nebeneinander isoliert vorliegen können. Auf ihrer der gezeigten Außen- oder Oberseite des Substrats sind die Thermoelemente 530, 531 vorzugsweise durch eine z. B. durchsichtige elektrisch isolierende Schicht abgedeckt (nicht gezeigt), die sich über die gesamte Oberseite des Thermoelementfühlers erstrecken kann. Weitere Ausführungen derartiger thermoanalytischer Sensoren sind beispielsweise in DE 39 163 11 A1 beschrieben.

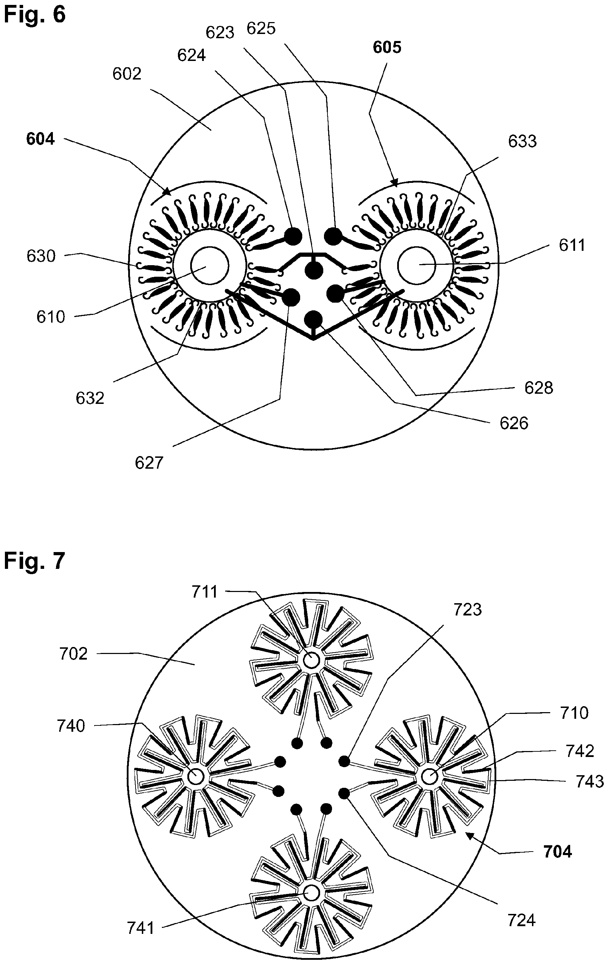

Figur 6 zeigt eine Aufsicht auf ein weiteres Ausführungsbeispiel eines thermoanalytischen Sensors mit einem scheibenförmigen keramischen Substrat 602, welches auf dessen Oberseite mit einer in Dickfilmtechnik aufgebrachten Temperatur-Sensoreinheit 604 versehen ist, die zur Lieferung von zur Durchführung der Differenz-Thermoanalyse geeigneten thermoelektrischen Signalen dient. Auf einem durch den Mittelpunkt des kreisscheibenförmigen Substrats 602 gezogenen Strahl liegen unter gleichem radialem Abstand zum Mittelpunkt die Messpositionen 610, 611, welche auch als Probenposition 610 und Referenzposition 611 bezeichnet werden können. Die Messposition 610 ist von einer Thermosäule aus hintereinandergeschalteten Thermoelementen 630 umgeben, jedes Thermoelement 630 besteht aus zwei verschiedenen Thermoelementmaterialien, welche sich in der Form geradliniger Streifen näherungsweise radial zwischen den Messpunkten oder Thermokontakten an den beiden Ende dieser Streifen erstrecken, so dass die Messpunkte abwechselnd in einem kleineren bzw. einem größeren radialen Abstand um die Messposition 610 angeordnet sind. Innerhalb des von den Thermoelementen 630 gebildeten radial inneren Kreises ist zudem auf dem Substrat 602 ein ringförmiges erstes Thermoelementmaterial 632 in zentrischer Anordnung relativ zum Zentrum der Messposition 610 ausgebildet. Die zweite Messposition 611 bzw. die Referenzposition ist im Wesentlichen gleich aufgebaut wie die erste Messposition 610 und ist mit einer weiteren Temperatur-Sensoreinheit 605 versehen.

Zwei elektrisch äquivalente Enden der beiden Temperatur-Sensoreinheiten 604, 605 sind durch eine auf dem Substrat 602 ausgebildete Kontaktstelle 623 zusammengeschaltet. Die beiden anderen Enden sind mittels Verbindungsstreifen zu je einer weiteren Kontaktstelle 624, 625 herausgeführt. Die Kontaktstellen 623, 624, 625 sind jeweils wie zuvor beschrieben an geeignete metallische Drähte gebondet, welche durch unter den Kontaktstellen 623 ,624, 625 liegenden Durchführungen aus der Unterseite des Substrats 602 herausgeführt werden. Die Drähte dienen dazu die Temperatur-Sensoreinrichtungen 604, 605 in einen elektronischen Schaltkreis einzubinden, um beispielsweise die Temperatur-Messsignale zu erfassen.

Zudem ist auf dem Substrat 602 eine weitere Kontaktstellenstruktur ausgebildet. Diese weist zwei spiegelsymmetrisch zwischen den beiden Messpositionen 610, 611 angeordnete Kontaktstellen 627, 628 auf, von denen aus sich ebenfalls jeweils spiegelsymmetrisch Anschlussstreifen in etwa radial zum ersten Thermoelementmaterial 623 bzw. 633 hin erstrecken und eine elektrische Verbindung zwischen letzterem und den Kontaktstellen 627, 628 herstellen. Die erforderliche elektrische Isolierung zwischen dieser Kontaktstellenstruktur und den davon überquerten Thermoelementstrukturen wird bei der Dickfilmherstellung berücksichtigt.

Weiterhin ist auf dem Substrat 602 eine weitere gemeinsame Kontaktstelle 626 ausgebildet, von der aus sich ein Verbindungsstreifen bis zu einer Y-förmigen Verzweigung erstreckt, von wo aus sich diese spiegelsymmetrisch unter Isolierung über die beiden Temperatur-Sensoreinheiten hinweg bis in die ringförmigen ersten Thermoelementmaterialien 632, 633 hinein erstreckt. Die Verbindungsstreifen bestehen aus einem zweiten Thermoelementmaterial, das mit dem ersten Thermoelementmaterial 632, 633 jeweils ein Thermoelement bildet. Das an diesen Thermoelementen auftretende Signal ist zwischen der gemeinsamen Kontaktstelle 626 und der jeweiligen Kontaktstelle 627 bzw. 628 als Absolut-Temperatur abgreifbar. Weitere Ausführungen derartiger Temperatur-Sensoreinheiten sind beispielsweise in DE 10 227 182 A1 beschrieben.

Figur 7 zeigt eine Aufsicht auf ein weiteres Ausführungsbeispiel eines thermoanalytischen Sensors mit vier auf einem Substrat 702 angeordneten Messpositionen 710, 711, 740, 741.

Die Messpositionen 710, 711, 740, 741 sind im Wesentlichen äquivalent und werden beispielhaft anhand der Messstelle 710 beschrieben.

Das Substrat 702 ist wiederum scheibenförmig und besteht aus einem der zuvor beschriebenen Materialien. Die Messstelle 710 ist mit einer in Dickfilmtechnik aufgebrachten Temperatur-Sensoreinheit 704 versehen. Die Temperatur-Sensoreinheit besteht aus einer Vielzahl von Thermoelementen 742, 743, welche aus zwei abwechselnd in Streifen aufgebrachten Thermoelementmaterialien bestehen. Die Thermoelemente 742, 743 sind als Doppelstern angeordnet, so dass die Temperatur-Sensoreinheit 704 die die Messposition 710 mit Messpunkten umgibt, welche auf vier konzentrischen Kreisen um die Messposition herum ausgebildet sind. Diese Anordnung der Thermoelemente ist besonders vorteilhaft, da sie die Ausbildung einer grossen Anzahl von Messpunkten ermöglicht.

Die Thermoelemente sind in Reihe geschaltet und enden in zwei Kontaktstellen 723, 724 im mittleren Bereich des Substrats 702. Die Temperatur-Sensoreinheit 704 ist mittels geeigneter metallischer Drähte, welche von unten durch das Substrat 702 hindurch geführt sind an die Kontaktstellen 723, 724 wie bereits zuvor beschrieben gebondet. Weitere Ausführungen derartiger Temperatur-Sensoreinheiten sind beispielsweise in EP 1 528 392 A1 beschrieben.

Sowohl in Figur 6 als auch in Figur 7 ist zu erkennen, dass ein erfindungsgemässer thermoanalytischer Sensor sehr vorteilhaft ist, da alle Kontaktstellen verhältnismässig eng zueinander in der Mitte des Sensors angeordnet werden können und sogar noch Platz für weitere Kontaktstellen und somit auch Sensoren mit weiteren elektronischen Elemente und/oder mehr als vier Messpositionen auf dem Substrat realisiert werden können. Die Strukturen auf der Oberseite der thermoanalytische Sensoren können wie bereits beschrieben in Dick- oder Dünnfilmtechnik realisiert werden. Eine weitere Möglichkeit besteht darin das Substrat in der sogenannten LTCC (Low Temperature Cofired Ceramics) Technik herzustellen.

Bei diesem Verfahren werden Platten aus einem keramischen Material im sogenannten grünen Zustand aufeinander gestapelt und gemeinsam gesintert, so dass eine einheitliche Struktur entsteht. Jede einzelne Platte kann im grünen Zustand bearbeitet oder bedruckt werden, so dass es möglich wird eine in Dünn- oder Dickfilmtechnik aufgebrachte Temperatur-Sensoreinheit oder andere elektronische Elemente in oder über mehrere Schichten oder Lagen des fertigen Sensors zu realisieren. Auf diese Weise können einerseits sehr viel mehr Messpunkte um eine einzelne Messposition herum angeordnet werden, zudem wird es sogar möglich dreidimensionale Temperatur-Sensoranordnungen herzustellen. Auch derartig hergestellte Sensoren können mit dem zuvor beschriebenen Bonding-Verfahren kontaktiert werden. Beispiele für thermoanalytische Sensoren mit Temperatur-Sensoreinheiten, welche mit dem LTCC Verfahren hergestellt wurden, sind beispielsweise in EP 1 875 181 A1 offenbart.

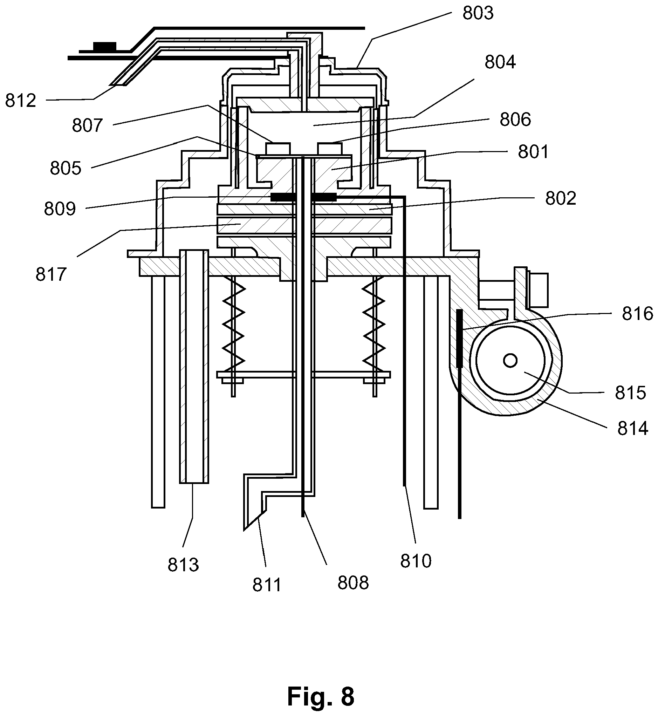

Figur 8 zeigt schematisch einen Vertikalschnitt durch ein DSC Gerät in welchem ein erfindungsgemässer thermoanalytischer Sensor eingesetzt werden kann. Das DSC Gerät weist einen hohlen zylindrischen Ofenblock 801 aus Silber auf, der von einer flachen Widerstandsheizung 802 beheizbar ist. Der Ofenblock 801 ist an seinem oberen Ende von einer Deckelanordnung 803 abgeschlossen, die abgenommen werden kann, um einen Zugang in das Innere 804 des Ofenblocks 801 zum Zwecke der Beschickung zu ermöglichen.

Im Inneren 804 des Ofenblocks 801 erstreckt sich ein thermoanalytischer Sensor mit einem scheibenförmigen Substrat 805, welcher mit dem Ofenblock 801 thermisch gekoppelt ist.

Auf der sich horizontal erstreckenden oberen Radialebene des scheibenförmigen Substrats 805 befindet sich eine erste Messposition zur Aufnahme eines Probentiegels 806 und eine dazu thermisch symmetrisch angeordnete zweite Messposition als Referenzposition, welche wie hier gezeigt zur Aufnahme eines Referenztiegels 807 dienen kann. Die Positionen des Probentiegels 806 und des Referenztiegels 807 sind mit je einer Temperatur-Sensoreinheit versehen. In dem dargestellten Ausführungsbeispiel sind zwei elektrisch entgegengesetzte Enden der beiden Temperatur-Sensoreinheiten auf dem Substrat 805 zusammengeschaltet, während die beiden anderen Enden auf zwei nur schematisch angedeuteten Leitungen 808 aus dem Ofenblock 1 herausgeführt sind. Bei den beiden Leitungen 808 handelt es sich um die zuvor beschriebenen metallischen Drähte welche an die Temperatur-Sensoreinheiten gebondet sind. Dies hat zur Folge, dass auf den beiden Leitungen 808 ein dem Temperaturunterschied zwischen der Probenposition und der Referenzposition entsprechendes thermoelektrisches Signal auftritt. Dieses thermoelektrische Signal entspricht in bekannter Weise der Differenz der beiden Wärmeströme, die zwischen dem Ofenblock 801 und dem Probentiegel 806 einerseits sowie dem Ofenblock 801 und dem Referenztiegel 807 andererseits fließen.

Die Widerstandsheizung 802 ist in nicht dargestellter Weise an eine gesteuerte Leistungsquelle angeschlossen, welche elektrische Heizenergie liefert. Die Steuerung erfolgt derart, dass ein vorgegebener dynamischer Temperaturverlauf als Funktion der Zeit durchlaufen wird. Dieser Temperaturverlauf wird mit einem in dem Ofenblock 801 angeordneten Temperatursensor 809 erfasst, dessen Ausgangssignal auf einer schematisch dargestellten Signalleitung 810 aus dem Ofenblock 801 herausgeführt ist. Die Signalleitung 810 führt also ein Signal, das dem vorgegebenen Temperaturverlauf entspricht.

Die Bezugszeichen 811, 812 und 813 bezeichnen eine Spülgaszuführungsleitung, eine Spülgasabführungsleitung bzw. eine Trockengaszuführungsleitung. Ferner bezeichnen in bekannter Weise die Bezugszeichen 814, 815 und 816 einen Kühlflansch, einen Kühlfinger bzw. einen Temperatursensor. Zwischen der Kühlanordnung 814, 815 und der Widerstandsheizung 802 ist ein Wärmewiderstand 817 angeordnet.

Bei diesem Differenzkalorimeter dient der Temperaturverlauf, dem eine Probe in dem Probentiegel 806 innerhalb des Ofenblocks 801 ausgesetzt ist, als Anregung. Das den Temperaturverlauf darstellende Signal auf der Signalleitung 810 wird von einer Auswerteeinrichtung mit hinreichend großer Abtastrate abgetastet und nach der Zeit differenziert, wodurch die Zeitableitung des Temperaturverlaufs, d. h. die Heizrate, erhalten wird. Synchron dazu wird auch das auf der Leitung 808 auftretende Temperaturdifferenzsignal abgetastet, das den Differenzwärmestrom als Antwort auf die Anregung darstellt.

Obwohl die Erfindung durch die Darstellung spezifischer Ausführungsbeispiele beschrieben worden ist, ist es offensichtlich, dass zahlreiche weitere Ausführungsvarianten in Kenntnis der vorliegenden Erfindung geschaffen werden können, beispielsweise indem die Merkmale der einzelnen Ausführungsbeispiele miteinander kombiniert und/oder einzelne Funktionseinheiten der Ausführungsbeispiele ausgetauscht werden.

### Liste der Bezugszeichen

- 1, 201, 401: Sensor
- 2, 202, 302, 402, 602, 702: Substrat
- 3, 203, 303: Hülse
- 4, 204, 404, 504, 604, 704: Temperatur-Sensoreinheit
- 5, 205, 605: Temperatur-Sensoreinheit
- 6, 206, 306: Kontaktstelle
- 7, 207, 307: Draht
- 8, 308: Durchführung
- 10, 210, 410, 510, 610, 710: Messposition
- 11, 211, 611, 711: Messposition
- 50, 250, 350: Schicht
- 209: Schaltkreis
- 212: Heizwiderstand
- 213: Kontaktstelle
- 214: Heizwiderstand
- 215: Kontaktstelle
- 316: Draht
- 317: Durchführung
- 319: Werkzeug
- 320: Metallkugel
- 321: Metallkugel
- 323, 423, 523, 623, 723: Kontaktstelle
- 325, 424, 524, 624, 724: Kontaktstelle
- 625: Kontaktstelle
- 626: Kontaktstelle
- 627: Kontaktstelle
- 628: Kontaktstelle
- 430, 530, 630: Thermoelement
- 431, 531: Thermoelement
- 632: Thermoelementmaterial
- 633: Thermoelementmaterial
- 740: Messposition
- 741: Messposition
- 742: Thermoelement
- 743: Thermoelement
- 801: Ofenblock
- 802: Widerstandsheizung
- 803: Deckelanordnung
- 804: Innere des Ofenblocks
- 805: Substrat
- 806: Probentiegel
- 807: Referenztiegel
- 808: Leitung
- 809: Temperatursensor
- 810: Signalleitung
- 811: Spülgaszuführungsleitung
- 812: Spülgasabführungsleitung
- 813: Trockgaszuführungsleitung
- 814: Kühlflansch
- 815: Kühlfinger
- 816: Temperatursensor
- 817: Wärmewiderstand

## Patentansprüche

1. Verfahren zur Herstellung eines thermoanalytischen Sensors, insbesondere eines DSC-Sensors, welcher ein Substrat mit einer Oberseite und einer Unterseite, mindestens eine Messposition, mindestens eine Temperatur-Sensoreinheit und mindestens eine elektrische Kontaktstelle umfasst;
die Messposition, die Temperatur-Sensoreinheit und die elektrische Kontaktstelle sind auf der Oberseite des Sensors ausgebildet, wobei die Temperatur-Sensoreinheit die Temperatur an der Messposition erfasst;
und die Temperatur-Sensoreinheit ist über die elektrische Kontaktstelle mit einem metallischen Draht zur Einbindung in eine elektronische Schaltung verbunden;
wobei das Verfahren die folgenden Schritte umfasst
a. Bereitstellen des Substrats;
b. Erzeugen von mindestens einer Messposition, mindestens einer Temperatur-Sensoreinheit und mindestens einer elektrischen Kontaktstelle auf der Oberseite des Substrats;
c. Erzeugen einer Durchführung im Substrat zur Kontaktierung der elektrischen Kontaktstelle;
d. Einführen eines metallischen Drahts in die Durchführung von der Unterseite des Substrat aus;
**gekennzeichnet durch**
e. Aufschmelzen des oberen Endes des metallischen Drahts unter Ausbildung einer Metallkugel;
f. Ausbildung einer stoffschlüssigen Verbindung als Bondstelle zwischen dem oberen Ende des metallischen Drahts und der elektrischen Kontaktstelle **durch** Einwirken von Druck- und Temperatur auf die Metallkugel.

2. Verfahren gemäss Anspruch 1, **dadurch gekennzeichnet, dass** das Verfahren ferner die Ausbildung von zwei oder mehr Messpositionen und zwei oder mehr Temperatur-Sensoreinheiten auf der Oberseite des Sensors umfasst, wobei jeder Messposition eine individuelle Temperatur-Sensoreinheit zugeordnet ist.

3. Verfahren gemäss einem der Ansprüche 1 oder 2, **dadurch gekennzeichnet, dass** die Temperatur-Sensoreinheit als Thermoelementanordnung ausgebildet ist, welche mindesten zwei Thermoelemente umfasst, die in einer oder mehreren Lagen auf der Oberseite des Sensors ausgebildet werden.

4. Verfahren gemäss einem der Ansprüche 1 bis 3, **dadurch gekennzeichnet, dass** das Verfahren ferner die Ausbildung mindestens eines Heizwiderstands und mindestens einer weiteren elektrischen Kontaktstelle auf der Oberseite des Sensors sowie die Ausbildung einer weiteren Durchführung im Sensor umfasst, wobei der Heizwiderstand zum Heizen der mindestens einen Messposition dient und über die elektrische Kontaktstelle mit einem weiteren metallischen Draht zur Verbindung mit einer elektrischen Stromversorgung verbunden ist, wobei zwischen einer am oberen Ende des weiteren metallischen Drahts ausgebildeteten Metallkugel und der elektrischen Kontaktstelle eine stoffschlüssige Verbindung in Form einer Bondstelle erzeugt wird.

5. Verfahren gemäss einem der Ansprüche 1 bis 4, **dadurch gekennzeichnet, dass** die Temperatur-Sensoreinheit, der Heizwiderstand und/oder die elektrische Kontaktstelle in Dick- oder Dünnfilmtechnik auf der Oberseite des Sensors ausgebildet werden.

6. Verfahren gemäss einem der Ansprüche 1 bis 5, **dadurch gekennzeichnet, dass** die metallischen Drähte mindestens eines der folgenden Metalle oder Mischungen daraus umfassen: Gold, Palladium und Kupfer.

7. Verfahren gemäss einem der Ansprüche 1 bis 6, **dadurch gekennzeichnet, dass** der metallische Draht einen Durchmesser zwischen ca. 0 mm und ca. 1 mm, vorzugsweise zwischen ca. 0 mm und ca. 0.5 mm und insbesondere einen Durchmesser von ca. 0.1 mm hat.

8. Verfahren gemäss einem der Ansprüche 1 bis 7, **dadurch gekennzeichnet, dass** die Metallkugel einen Durchmesser von ca. 0.01 bis ca. 0.25 mm hat.

9. Verfahren gemäss einem der Ansprüche 1 bis 8, **dadurch gekennzeichnet, dass** die elektronische Schaltung so ausgelegt wird, dass mit dem Sensor eine DSC Messung nach der Prinzip der Power Compensation und/oder dem Heatflux-Prinzip durchgeführt wird.

10. Thermoanalytischer Sensor, insbesondere ein DSC-Sensor, welcher ein Substrat mit einer Oberseite und einer Unterseite umfasst, auf dessen Oberseite mindestens eine Messposition, eine Temperatur-Sensoreinheit und mindestens eine elektrische Kontaktstelle ausgebildet sind, die Temperatur-Sensoreinheit ist zur Erfassung der Temperatur der Messposition geeignet und die Temperatur-Sensoreinheit ist über die elektrische Kontaktstelle mit mindestens einem metallischen Draht zur Einbindung in eine elektronische Schaltung verbunden, **dadurch gekennzeichnet, dass** der metallische Draht von der Unterseite des Substrats in eine im Substrat ausgebildete Durchführung eingebracht und an dessen oberen Ende eine Metallkugel ausgebildet ist, wobei die Metallkugel unter Druck- und Temperatureinwirkung eine stoffschlüssige Verbindung als Bondstelle zwischen dem oberen Ende des metallischen Drahts und der elektrischen Kontaktstelle ausbildet.

11. Thermoanalytischer Sensor gemäss Anspruch 10, **dadurch gekennzeichnet, dass** der Sensor ferner mindestens einen Heizwiderstand und mindestens eine weitere elektrische Kontaktstelle umfasst, welche auf der Oberseite des Sensors ausgebildet sind, wobei der Heizwiderstand über die elektrische Kontaktstelle mit einem weiteren metallischen Draht zur Verbindung mit einer elektrischen Stromversorgung verbunden ist und zum Heizen der mindestens einen Messposition dient.

12. Thermoanalytischer Sensor gemäss Anspruch 10 oder 11, **dadurch gekennzeichnet, dass** das Substrat mindestens eines der folgenden nichtleitenden Materialien oder Mischungen daraus umfasst: Aluminiumoxid, Steatit, Aluminiumnitrid oder Glaskeramik.

13. Thermoanalytischer Sensor gemäss Anspruch 10 oder 11, **dadurch gekennzeichnet, dass** das Substrat mindestens eines der folgenden leitenden Materialien oder Mischungen daraus umfasst: Stahl oder ein Hartmetall.

14. Thermoanalytischer Sensor gemäss einem der Ansprüche 10 bis 13 **dadurch gekennzeichnet, dass** das Substrat im Wesentlichen scheibenförmig ist.

## Claims

1. Method of manufacturing a thermoanalytical sensor, specifically a differential scanning calorimetry sensor, which includes a substrate with a top side and an underside, at least one measurement position, at least one temperature sensor unit, and at least one electrical contact pad, wherein the at least one measurement position, the at least one temperature sensor unit and the electrical contact pad are arranged on the top side of the sensor, with the temperature sensor unit measuring the temperature at the measurement position, and wherein the temperature sensor unit is connected by way of the electrical contact pad to a metallic wire and thereby tied into an electronic circuit;
the method comprising the steps of
a. preparing the substrate;
b. producing at least one measurement position, at least one temperature sensor unit and at least one electrical contact pad on the top side of the substrate;
c. making a passage in the substrate for the connection to the electrical contact pad;
d. inserting a metallic wire into the passage from the underside of the substrate; **characterized by**
e. melting the upper end of the wire and thereby forming a metal ball; and
f. completing the bond in the form of a materially integral connection between the upper end of the metallic wire and the electrical contact pad through the application of pressure and heat to the metal ball.

2. Method according to claim 1, **characterized in that** the method further comprises forming two or more measurement positions and two or more temperature sensor units on the top side of the sensor, wherein an individually dedicated temperature sensor unit is assigned to each measurement position.

3. Method according to one of the claims 1 or 2, **characterized in that** the temperature sensor unit is configured as a thermocouple arrangement comprising at least two thermocouples that are formed in one or more layers on the top side of the sensor.

4. Method according to one of the claims 1 to 3, **characterized in that** the method further comprises forming at least one heating resistor and at least one further electrical contact pad on the top side of the sensor, as well as forming a further passage through the sensor, wherein the heating resistor, which serves to heat the at least one measurement position, is connected by way of the electrical contact pad and a further metallic wire to an electrical power supply source, and wherein a materially integral connection in the form of a bonded joint is formed between the electrical contact pad and a metal ball that is formed at the upper end of the further metallic wire.

5. Method according to one of the claims 1 to 4, **characterized in that** the temperature sensor unit, the heating resistor and/or the electrical contact pad are produced in thick film or thin film technology on the top side of the sensor.

6. Method according to one of the claims 1 to 5, **characterized in that** the metallic wires include at least one of the following metals or their alloys: gold, palladium, and copper.

7. Method according to one of the claims 1 to 6, **characterized in that** the metallic wire has an approximate diameter between 0 mm and 1 mm, preferably between 0 mm and 0.5 mm, and in particular a diameter of about 0.1 mm.

8. Method according to one of the claims 1 to 7, **characterized in that** the metal ball has a diameter of approximately 0.01 to 0.25 mm.

9. Method according to one of the claims 1 to 8, **characterized in that** the electronic circuit is designed so that the sensor can be used for DSC measurements according to the principle of power compensation and/or according to the heat flux principle.

10. Thermoanalytical sensor, in particular a DSC sensor comprising a substrate with a top side and an underside, wherein at least one measurement position, one temperature sensor unit and at least one electrical contact pad are formed on the top side, wherein the temperature sensor unit is suitable for detecting the temperature of the measurement position and the temperature sensor unit is connected by way of the electrical contact pad to at least one metallic wire and thereby tied into an electronic circuit, **characterized in that** the metallic wire enters from the underside of the substrate into a passage that is formed in the substrate, and that the wire is terminated at its upper end by a metal ball which, through the application of pressure and temperature, forms a materially integral connection in the form of a bonded junction between the upper end of the metallic wire and the electrical contact pad.

11. Thermoanalytical sensor according to claim 10, **characterized in that** the sensor further comprises at least one heating resistor and at least one further electrical contact pad which are formed on the top side of the sensor, wherein the heating resistor, which serves to heat the at least one measurement position, is connected by way of the electrical contact pad and a further metallic wire to an electrical power supply source.

12. Thermoanalytical sensor according to claim 10 or 11, **characterized in that** the substrate comprises at least one of the following non-conductive materials or mixtures thereof: aluminum oxide, steatite, aluminum nitrite, or glass ceramics.

13. Thermoanalytical sensor according to claim 10 or 11, **characterized in that** the substrate comprises at least one of the following conductive materials or mixtures thereof: steel or a hard metal.

14. Thermoanalytical sensor according to one of the claims 10 to 13, **characterized in that** the substrate is substantially disk-shaped.

## Revendications

1. Procédé pour la fabrication d'un capteur thermoanalytique, en particulier un capteur DSC, comprenant un substrat avec une face supérieure et une face inférieure, au moins une position de mesure, au moins une unité de capteur de température et au moins une zone de contact électrique; dans lequel la position de mesure, l'unité de capteur de température et la zone de contact électrique sont formées sur la face supérieure du capteur, l'unité de capteur de température détectant la température au niveau de la position de mesure; et dans lequel l'unité de capteur de température est reliée à un fil métallique par le biais de la zone de contact électrique, pour l'intégration dans un circuit électronique;
le procédé comprenant les étapes suivantes:
a. mise à disposition du substrat;
b. fabrication d'au moins une position de mesure, d'au moins une unité de capteur de température et d'au moins une zone de contact électrique sur la face supérieure du substrat;
c. fabrication d'un passage dans le substrat, pour la mise en contact de la zone de contact électrique;
d. insertion du fil métallique dans le passage à partir de la face inférieure du substrat;
**caractérisé en ce que**
e. fusion de l'extrémité supérieure du fil métallique en formant une bille de métal;
f. formation d'une liaison par adhérence comme zone d'assemblage entre l'extrémité supérieure du fil métallique et la zone de contact électrique par l'action de la pression et de la température sur la bille de métal.

2. Procédé selon la revendication 1, **caractérisé en ce que** le procédé comprend en outre la formation de deux ou plusieurs positions de mesure et de deux ou plusieurs unités de capteur de température sur la face supérieure du capteur, dans lequel une unité de capteur de température individuelle est attribuée à chaque position de mesure.

3. Procédé selon l'une des revendications 1 ou 2, **caractérisé en ce que** l'unité de capteur de température est conçue comme un ensemble d'éléments thermiques comprenant au moins deux éléments thermiques, lesquels sont formés en une ou plusieurs couches sur la face supérieure du capteur.

4. Procédé selon l'une des revendications 1 à 3, **caractérisé en ce que** le procédé comprend en outre la formation d'au moins une résistance de chauffage et au moins une zone de contact électrique supplémentaire sur la face supérieure du capteur, ainsi que la formation d'un passage supplémentaire dans le capteur, la résistance de chauffage servant à chauffer l'au moins une position de mesure et étant reliée à un fil métallique supplémentaire par le biais de la zone de contact électrique, pour le raccordement à une alimentation électrique, une liaison par adhérence sous la forme d'une zone d'assemblage étant réalisée entre une bille de métal formée à l'extrémité supérieur du fil métallique supplémentaire et la zone de contact électrique.

5. Procédé selon l'une des revendications 1 à 4, **caractérisé en ce que** l'unité de capteur de température, la résistance de chauffage et/ou la zone de contact électrique sont formées selon une technique de film épais ou fin sur la face supérieure du capteur.

6. Procédé selon l'une des revendications 1 à 5, **caractérisé en ce que** les fils métalliques comprennent l'un des métaux suivants ou un alliage de ceux-ci: or, palladium et cuivre.

7. Procédé selon l'une des revendications 1 à 6, **caractérisé en ce que** le fil métallique présente un diamètre d'environ 0 mm à environ 1 mm, de préférence d'environ 0 mm à environ 0,5 mm et en particulier un diamètre d'environ 0,1 mm.

8. Procédé selon l'une des revendications 1 à 7, **caractérisé en ce que** la bille de métal présente un diamètre d'environ 0,01 à environ 0,25 mm.

9. Procédé selon l'une des revendications 1 à 8, **caractérisé en ce que** le circuit électronique est conçu de manière à ce qu'une mesure DSC puisse être exécutée selon le principe de la compensation de puissance et/ou le principe de flux de chaleur.

10. Capteur thermoanalytique, selon un capteur DSC, comprenant un substrat avec une face supérieure et une face inférieure, sur la face supérieure duquel sont formées au moins une position de mesure, une unité de capteur de température et au moins une zone de contact électrique, l'unité de capteur de température étant adaptée pour détecter la température de la position de mesure, et l'unité de capteur de température étant reliée à au moins un fil métallique par le biais de la zone de contact électrique, pour l'intégration dans un circuit électronique, **caractérisé en ce que** le fil métallique est inséré dans un passage formé dans le substrat par la face inférieure du substrat et **en ce qu'**une bille de métal est formée à l'extrémité supérieure de celui-ci, la bille de métal formant une liaison par adhérence comme zone d'assemblage entre l'extrémité supérieure du fil métallique et la zone de contact électrique, sous l'action de la pression et de la température.

11. Capteur thermoanalytique selon la revendication 10, **caractérisé en ce que** le capteur comprend en outre au moins une résistance de chauffage et au moins une zone de contact électrique supplémentaire, lesquelles sont formées sur la face supérieure du capteur, la résistance de chauffage étant reliée à un fil métallique supplémentaire par le biais de la zone de contact électrique, pour le raccordement à une alimentation électrique, et servant à chauffer l'au moins une position de mesure.

12. Capteur thermoanalytique selon la revendication 10 ou 11, **caractérisé en ce que** le substrat comprend au moins l'un des matériaux non-conducteurs suivants ou des combinaisons de ceux-ci: oxyde d'aluminium, stéatite, nitrure d'aluminium ou céramique de verre.

13. Capteur thermoanalytique selon la revendication 10 ou 11, **caractérisé en ce que** le substrat comprend au moins l'un des matériaux conducteurs suivants ou des combinaisons de ceux-ci: de l'acier ou un métal dur.

14. Capteur thermoanalytique selon l'une des revendications 10 à 13, **caractérisé en ce que** le substrat présente essentiellement une forme de disque.
